# EUROPÄISCHE PATENTANMELDUNG

(11) **EP 0 548 802 A1**
(43) Veröffentlichungstag der Anmeldung: **30.06.1993**
(21) Anmeldenummer: 92121477.1
(22) Anmeldetag: 17.12.1992
(51) Int. Cl.: C04B 35/58, H01L 23/15

(54) **Keramischer Verbundwerkstoff mit definierter thermischer Ausdehnung**

(30) Priorität: 20.12.1991 DE 4142412
(71) Anmelder: Elektroschmelzwerk Kempten GmbH, D-81737 München (DE)
(72) Erfinder: Lange, Dietrich, Dr., W-8960 Kempten (DE); Eyhorn, Thomas, Dipl.-Ing., W-8963 Waltenhofen (DE)

(57) **Zusammenfassung**

Die Erfindung betrifft keramische Verbundwerkstoffe mit definierter thermischer Ausdehnung. Der keramische Verbundwerkstoff dient als Substrat für elektronische Bauelemente. Er ist dadurch gekennzeichnet, daß sein thermischer Ausdehnungskoeffizient dem thermischen Ausdehnungskoeffizienten von Silicium entspricht. Der keramische Verbundwerkstoff besteht aus mindestens zwei kristallinen Phasen, wobei neben einer kristallinen Si₃N₄-Phase die zweite kristalline Phase und jede weitere kristalline Phase aus je einer Substanz, ausgewählt aus der Gruppe der Carbide, Oxide und Nitride der Übergangsmetalle der 4. bis 6. Nebengruppe des Periodensystems Aluminiumoxid, Bornitrid und Aluminiumnitrid, besteht.

## Beschreibung

Die Erfindung betrifft keramische Verbundwerkstoffe mit definierter thermischer Ausdehnung.

In der Mikroelektronik werden keramische Verbundwerkstoffe unter anderem als Trägermaterial für elektronische Schaltungen verwendet. Das Trägermaterial, auch Substrat genannt, hat dabei die Aufgabe, die elektronische Schaltung, auch Chip genannt, mit ihren feinen Strukturen mechanisch zu stützen und zu verstärken. Gleichzeitig nimmt das Substrat, das aus elektrisch isolierendem Material bestehen muß, die elektrischen Kontakte auf. Erst die Kombination von elektronischer Schaltung (Chip) und Trägermaterial (Substrat) stellt ein handhabbares, mechanisch hinlänglich widerstandsfähiges Bauelement dar, welches auch als IC (integrated circuit, integrierte Schaltung) bezeichnet wird. Die Verbindung von elektronischer Schaltung und Trägermaterial ist kraftschlüssig. Sie wird durch Kleben oder Löten mit metallischen oder glasartigen Loten realisiert.

Die in dem Chip in Wärme umgesetzte Verlustleistung erwärmt sowohl den Chip als auch das Substrat. Das Substrat wird bewußt zur Wärmeabfuhr eingesetzt und daher aus Materialien ausgewählt, die eine hohe Wärmeleitfähigkeit haben. Folgende Werkstoffe werden derzeit als Substratwerkstoffe verwendet:
1. Aluminiumoxid (Al₂O₃); Al₂O₃ wird für thermisch höher belastete und hochwertigere Bauelemente eingesetzt.
2. Kunststoffe; Kunststoffe werden für billige Massenprodukte mit geringer thermischer Belastung eingesetzt.
3. Berylliumoxid (BeO); BeO hat eine extrem hohe thermische Leitfähigkeit und ist gleichzeitig elektrisch isolierend. Das Material ist zwar relativ billig, hat jedoch den großen Nachteil, daß die bei der Verarbeitung entstehenden Stäube hochgiftig sind bzw. tödlich verlaufende allergische Reaktionen bei Menschen hervorrufen können. Beryllium muß daher unter besonderen Schutzmaßnahmen verarbeitet werden.
4. Aluminiumnitrid (AlN); AlN besitzt ebenfalls eine beträchtliche Wärmeleitfähigkeit. Sie hängt stark von der Herstellmethode und der Reinheit des Materials ab. Aluminiumnitrid ist eine ungiftige und daher umweltschonende Alternative zum Berylliumoxid, die allerdings teuer ist.

Die genannten Materialien haben die in der folgenden Tabelle genannten thermischen Ausdehnungskoeffizienten. Sie unterscheiden sich in dieser Eigenschaft stark vom Silicium.

| Werkstoff | therm. Ausdehnungskoeffizient in Temp. Bereich | |
|---|---|---|
| Al₂O₃ | 6,3 x 10⁻⁶ K⁻¹ | (20 - 300°C) |
| Kunststoff | 20-40 x 10⁻⁶ K⁻¹ | (20 - 100°C) |
| BeO | 5,4 x 10⁻⁶ K⁻¹ | (20 - 100°C) |
| | 8,9 x 10⁻⁶ K⁻¹ | (20 - 1000°C) |
| AlN | 4,3 x 10⁻⁶ K⁻¹ | (20 - 500°C) |
| | 4,8 x 10⁻⁶ K⁻¹ | (20 - 800°C) |
| Silicium | 3,4 x 10⁻⁶ K⁻¹ | (20 - 100°C) |
| | 3,6 x 10⁻⁶ K⁻¹ | (20 - 500°C) |

Trotz der guten Wärmeleitfähigkeit der bekannten Substrate kommt es bei der Herstellung (Auflöten des Chips auf das Substrat) und im Betrieb zu einer erheblichen Erwärmung des Bauelements (Chip + Substrat). Diese Erwärmung der Komponenten hat aufgrund der unterschiedlichen thermischen Ausdehnungskoeffizienten von Substrat und Chip mechanische Spannungen in beiden Komponenten zur Folge, die im Extremfall das Bauelement zerstören können (Bimetalleffekt). Solche Spannungen begrenzen sowohl die flächenmäßige Größe als auch den Einsatzbereich der Bauelemente.

Aufgabe der Erfindung war es, einen keramischen Verbundwerkstoff als Trägermaterial für elektronische Schaltkreise zur Verfügung zu stellen, der keine Störeinflüsse aufgrund unterschiedlicher thermischer Ausdehnung auf die integrierte Schaltung ausübt.

Die Aufgabe wird gelöst durch einen keramischen Verbundwerkstoff als Substrat für elektronische Bauelemente mit einem thermischen Ausdehnungskoeffizienten, der dem thermischen Ausdehnungskoeffizienten von Silicium entspricht.

Die thermischen Ausdehnungskoeffizienten entsprechen sich im Sinne der vorliegenden Erfindung, wenn die Wertedifferenz der thermischen Ausdehnungskoeffizienten über den Temperaturbereich von 20°C bis 500°C kleiner als 0,1 x 10⁻⁶ K⁻¹ ist.

Der erfindungsgemäße keramische Werkstoff besteht aus mindestens zwei kristallinen Phasen. Eine der kristallinen Phasen besteht immer aus β-Siliciumnitrid. Die zweite kristalline Phase besteht aus einer Substanz ausgewählt aus der Gruppe der Carbide, Oxide und Nitride der Übergangsmetalle der 4. bis 6. Nebengruppe des Periodensystems, Aluminiumoxid, Bornitrid und Aluminiumnitrid. Es können auch weitere Phasen ausgewählt aus den Substanzen der vorgenannten Gruppe in dem Werkstoff vorhanden sein.

Als zweite oder gegebenenfalls weitere Phasen sind bevorzugt Titannitrid, Aluminiumnitrid oder Aluminiumoxid geeignet. Besonders bevorzugt ist Titannitrid als zweite Phase geeignet.
In der Regel enthält der erfindungsgemäße keramische Verbundwerkstoff auch eine teilamorphe Phase. Diese entsteht während des Sinterns aus den eingesetzten oxidischen Sinteradditiven und den in den genannten Ausgangspulvern vorhandenen SiO₂-Verunreinigungen. Durch die Reaktion zwischen den oxidischen Sinteradditiven und dem SiO₂ verändern sich die Volumenverhältnisse zwischen den Ausgangsstoffen und den Phasen im gesinterten Werkstoff geringfügig.

Die Ausgangszusammensetzung des keramischen Werkstoffs besteht erfindungsgemäß aus:
94,9 - 27 Vol.% Siliciumnitrid
5 - 65 Vol.% mindestens einer Substanz, ausgesucht aus der Gruppe der Carbide, Oxide und Nitride der Übergangsmetalle der 4. bis 6. Nebengruppe des Periodensystems, Aluminiumoxid, Bornitrid und Aluminiumnitrid und
0,1 - 8 Vol.% mindestens einem Sinteradditiv.

Bevorzugt ist die Ausgangspulvermischung des Verbundwerkstoffs wie folgt:
94 - 65 Vol.% erste kristalline Phase
5 - 30 Vol.% mindestens eine Substanz ausgewählt aus der Gruppe Titannitrid, Aluminiumnitrid oder Aluminiumoxid
1 - 5 Vol.% mindestens ein Sinteradditiv.

Besonders bevorzugt ist folgende Ausgangszusammensetzung des keramischen Werkstoffs:
83,5 - 80 Vol.% erste kristalline Phase
14 - 15 Vol.% Titannitrid
2,5 - 5 Vol.% mindestens ein Sinteradditiv.

Zur Herstellung des Verbundwerkstoffs ist bevorzugt handelsübliches α-Siliciumnitrid-Pulver mit einer spezifischen Oberfläche zwischen 5 und 25 m²/g geeignet. Die weiteren genannten Substanzen sollten als Pulver einer Korngröße kleiner 10 µm, bevorzugt einer Korngröße kleiner 5 µm, eingesetzt werden.

Als Sinteradditive werden Y₂O₃, Al₂O₃, La₂O₃, MgO sowie deren Mischungen, bevorzugt Al₂O₃ und/oder Y₂O₃, in bekannten Mengen eingesetzt.

Die Ausgangsstoffe werden in folgendem Verhältnis in bekannter Art, beispielsweise durch Kugelmühlen oder Artritoren gemischt.
94,9 - 27 Vol.% Siliciumnitrid
5 - 65 Vol.% mindestens einer der genannten Substanzen der zweiten kristallinen Phase
0,1 - 8 Vol.% mindestens ein Sinteraditiv.

Bevorzugt werden folgende Ausgangsmischungen eingesetzt.
94 - 65 Vol.% Siliciumnitrid
5 - 30 Vol.% mindestens einer Substanz, ausgewählt aus der Gruppe TiN, AlN, Al₂O₃
1 - 5 Vol.% mindestens ein Sinteraditiv.

Besonders bevorzugt sind folgende Mischungen geeignet:
83,5 - 80 Vol.% Siliciumnitrid
14 - 15 Vol.% Titannitrid
2,5 - 5 Vol.% Al₂O₃/Y₂O₃.

Die Formgebung erfolgt in bekannter Weise beispielsweise durch Gesenkpressen oder Folienguß.

Der Formkörper wird bei 1600 bis 1950°C in einer stickstoffhaltigen Atmosphäre bei einem Druck von 1 bis 2000 bar 10 Minuten bis 120 Minuten, bevorzugt 50 bis 70 Minuten, gesintert.

Neben der Herstellung der erfindungsgemäßen Verbundwerkstoffe aus den Pulvermischungen der im Endprodukt vorhandenen Substanzen ist es auch möglich, die angestrebten Phasen durch Reaktion während der Herstellung entstehen zu lassen. Beispielsweise läßt sich Titannitrid durch Reaktionssintern von titanhaltigen Ausgangspulvern (z.B. Titandiborid TiB₂) in einer stickstoffhaltigen Atmosphäre in situ erzeugen.

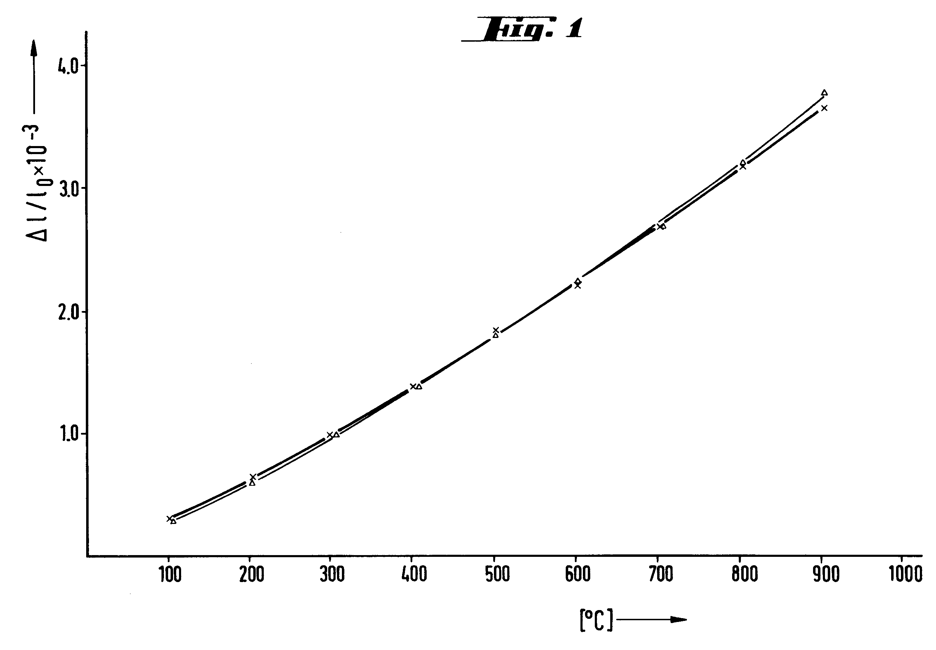

Die Übereinstimmung der thermischen Ausdehnungskoeffizienten vom erfindungsgemäßen Substratwerkstoff mit dem thermischen Ausdehnungskoeffizienten von Silicium reicht wie in Fig. 1 ersichtlich weit über die normalen Betriebstemperaturen von elektronischen Bauelementen hinaus bis in die Temperaturbereiche, die beim Befestigen des Chips auf dem Substrat auftreten.

Somit besteht bei Verwendung des erfindungsgemäßen Substratwerkstoffes nicht mehr die Gefahr, daß es nach dem Auflöten des Chips auf das Substrat, bei dem hohe Temperaturen (700°C bis 800°C) auftreten können, in der Abkühlphase zur Ablösung des Chips und damit zur Zerstörung des Bauelements kommt.

Der erfindungsgemäße Substratwerkstoff ist besonders für den Einsatz als Trägermaterial für solche elektronischen Schaltungen geeignet, bei denen es trotz der hohen Wärmeleitfähigkeit bekannter Substratwerkstoffe zu thermischen Problemen kommen kann. Er bietet im Vergleich zu den bekannten Substratwerkstoffen insbesondere dann Vorteile, wenn aufgrund thermischer Belastungen mechanische Spannungen zu Problemen führen können. Solche Probleme treten beispielsweise beim Einsatz von ICs auf den Gebieten der Sensorik, der Mikroelektronik oder der Mikromechanik auf. Besonders negativ wirken sich derartige Spannungen beispielsweise aus, wenn das elektronische Bauelement zur Messung von mechanischen Spannungen verwendet werden soll, wie das z.B. in Drucksensoren der Fall ist.

Sensoren sollen möglichst empfindlich Änderungen bzw. Absolutwerte derjenigen Meßgröße registrieren, für deren Erfassung sie konstruiert sind. Störeinflüsse, also die Änderung anderer Zustandsgrößen, sollen keinen Einfluß auf die Meßwerterfassung haben. Beispielsweise soll ein Drucksensor nicht auf Temperaturschwankungen oder Änderungen der rel. Feuchte reagieren. Bei elektronischen Bauelementen, bei denen Substrat und Chip unterschiedliche thermische Ausdehnung haben, müssen Störeinflüsse aufgrund dieser thermischen Fehlpassung bisher durch aufwendige Zusatzmaßnahmen, wie beispielsweise elektronische Kompensationsschaltungen oder mechanische Faltenstrukturen im Chip, kompensiert werden, was neben der erhöhten Fehleranfälligkeit auch die Herstellung der Chips verteuert. Der erfindungsgemäße Substratwerkstoff löst diese Probleme.

Fig. 1 stellt den thermischen Ausdehnungskoeffizienten des erfindungsgemäßen Werkstoffs gemäß Beispiel 1 (1) über einen Temperaturbereich von 900°C im Vergleich zu dem thermischen Ausdehnungskoeffizienten von für elektronische Schaltungen verwendetem, käuflich erwerblichem Silicium der Fa. Monsanto (2) dar (Meßpunkte von (1):Δ; Meßpunkte von (2): X).

Die Beispiele dienen zur weiteren Erläuterung der Erfindung.

### Beispiel 1:

69,4 Gew.-% α-Si₃N₄, 21,5 Gew.-% TiN und 9,1 Gew.-% Y₂O₃-Al₂O₃ einer Korngröße kleiner 10 µm wurden in einer Planetenkugelmühle (PKM) 18 h aufgemahlen und homogenisiert. Durch anschließendes Sprühtrocknen wurde ein gut preßbares, rieselfähiges Pulver hergestellt. Formteile (15x15x8 mm) wurden durch Gesenkpressen in einer Stahlmatrize bei 1300 bar erzeugt. Bei der anschließenden Sinterung (1850°C, 100 bar N₂, Haltezeit 1,0 Stunden) schwindet das Formteil linear um ca. 20%. Das erhaltene Formteil hatte eine Dichte von etwa 99,5% theoretischer Dichte (TD). Die Messung des Wärmeausdehnungskoeffizienten (WAK) mittels eines Präzisionsdilatometers ergibt einen durchschnittlichen Wert von α = 3,6 x 10-6 K⁻¹ im Bereich von 20°C - 500°C. Die Übereinstimmung des WAK von Silicium mit dem des beschriebenen Materials zeigt Fig. 1.

### Beispiel 2:

56,3 Gew.-% Si₃N₄, 40,8 Gew.-% AlN und 2,9 Gew.-% MgO einer Korngröße kleiner 10 µm wurden in einer PKM 18 Stunden aufgemahlen und homogenisiert, anschließend wurde durch Sprühtrocknen ein gut preßbares, rieselfähiges Pulver hergestellt.

Das Pulvergemisch wird in einer Graphitmatrize bei 1870°C und 15 MPa (150 bar), Haltezeit 45', heißgepreßt. Probekörper, die aus diesen heißgepreßten Platten herausgetrennt wurden, hatten einen WAK von 3,65 x 10⁻⁶ K⁻¹ im Temperaturbereich von 20°C - 500°C.

### Beispiel 3:

52 Gew.-% Si₃N₄, 45 Gew.-% Bornitrid (BN) und 3 Gew.-% MgO mit einer Korngröße kleiner 10 µm wurden in einer PKM 18 Stunden aufgemahlen und homogenisiert, anschließend wurde durch Sprühtrocknen ein gut preßbares, rieselfähiges Pulver hergestellt.

Das Pulvergemisch wird in einer gummielastischen Hülle bei 2000 bar isostatisch gepreßt. Der so erhaltene Rohkörper (Grünling) wird unter Berücksichtigung des Schwundmaßes auf die gewünschte Geometrie bearbeitet (Sägen, Fräsen, Bohren, Schleifen), in Quarzglas gekapselt und bei ca. 1825°C, 2000 bar und 1 Stunde Haltezeit heißisostatisch auf eine Dichte ≧ 99 % TD verdichtet.

Probekörper, die aus diesen heißgepreßten Platten herausgetrennt wurden, hatten einen WAK von 3,55 x 10⁻⁶ K⁻¹ im Temperaturbereich von 20°C - 500°C.

### Beispiel 4:

68.2 Gew.-% SN, 28,8 Gew.-% HfO₂ und 3 Gew.-% MgO wurden in einer PKM 18 Stunden aufgemahlen und homogenisiert, anschließend wurde durch Sprühtrocknen ein gut preßbares, rieselfähiges Pulver hergestellt.

Das Pulvergemisch wird in einer Graphitmatrize bei 1870°C und 15 MPa (150 bar), Haltezeit 45', heißgepreßt. Probekörper, die aus diesen heißgepreßten Platten herausgetrennt wurden, hatten einen WAK von 3,65 x 10⁻⁶ K⁻¹ im Temperaturbereich von 20°C - 500°C.

## Patentansprüche

1. Keramischer Verbundwerkstoff als Substrat für elektronische Bauelemente, dadurch gekennzeichnet, daß sein thermischer Ausdehnungskoeffizient dem thermischen Ausdehnungskoeffizienten von Silicium entspricht.

2. Keramische Verbundwerkstoffe nach Anspruch 1, dadurch gekennzeichnet, daß er aus mindestens zwei kristallinen Phasen besteht, wobei neben einer kristallinen Si₃N₄-Phase die zweite kristalline Phase und jede weitere kristalline Phase aus je einer Substanz, ausgewählt aus der Gruppe der Carbide, Oxide und Nitride der Übergangsmetalle der 4. bis 6. Nebengruppe des Periodensystems, Aluminiumoxid, Bornitrid und Aluminiumnitrid besteht.

3. Keramischer Verbundwerkstoff nach einem der Ansprüche 1 oder 2, dadurch gekennzeichnet, daß die zweite kristalline Phase und eventuell vorhandene weitere kristalline Phasen aus Aluminiumoxid, Bornitrid oder Aluminiumnitrid besteht.

4. Keramischer Verbundwerkstoff als Substrat für elektronische Bauelemente, dadurch gekennzeichnet, daß er
94,9 - 27 Vol.% Siliciumnitrid
5 - 65 Vol.% mindestens einer Substanz, ausgewählt aus der Gruppe der Carbide, Oxide und Nitride der Übergangsmetalle, Aluminiumoxid, Bornitrid und Aluminiumnitrid sowie
0,1 - 8 Vol.% mindestens eines Sinteradditivs enthält.

5. Keramischer Verbundwerkstoff als Substrat für elektronische Bauelemente, dadurch gekennzeichnet, daß er
94 - 65 Vol.% Siliciumnitrid
5 - 30 Vol.% mindestens einer Substanz, ausgewählt aus der Gruppe Aluminiumoxid, Bornitrid und Aluminiumnitrid sowie
1 - 5 Vol.% mindestens eines Sinteradditivs enthält.

6. Keramischer Verbundwerkstoff als Substrat für elektronische Bauelemente, dadurch gekennzeichnet, daß er
83,5 - 80 Vol.% Siliciumnitrid
14 - 15 Vol.% Titannitrid sowie
2,5 - 5 Vol.% mindestens eines Sinteradditivs enthält.

7. Herstellung des Verbundwerkstoffes nach einem der Ansprüche 1 bis 6, dadurch gekennzeichnet, daß Siliciumnitrid, mindestens eine Substanz ausgewählt aus der Gruppe der Carbide, Oxide und Nitride der Übergangsmetalle, Aluminiumoxid, Bornitrid und Aluminiumnitrid sowie ein Sinterhilfsmittel als Pulver einer Korngröße kleiner 10 µm gemischt, geformt und anschließend bei 1600°C bis 1950°C in einer stickstoffhaltigen Atmosphäre gesintert werden.

8. Verwendung der Verbundwerkstoffe nach einem der Ansprüche 1 bis 6 in elektronischen Bauelementen zur Messung von mechanischen Spannungen.

9. Verwendung der Verbundwerkstoffe nach einem der Ansprüche 1 bis 6 in Drucksensoren.

10. Verwendung eines Verbundwerkstoffs nach einem der Ansprüche 1 bis 6 in elektronischen Bauelementen, bei denen Chip und Substrat durch Löten verbunden wurden.
